# EUROPÄISCHE PATENTSCHRIFT

(11) **EP 1 438 756 B1**
(45) Veröffentlichungstag und Bekanntmachung des Hinweises auf die Patenterteilung: **09.04.2008**
(21) Anmeldenummer: 02774685.8
(22) Anmeldetag: 04.10.2002
(51) Int. Cl.: H01L 51/30, C09K 11/06, C09K 11/08, H05B 33/14, H05B 33/20

(54) **ELEKTROPHOSPHORESZIERENDE ANORDNUNG MIT LEITFÄHIGEN POLYMEREN**
ELECTROPHOSPHORESCENT ASSEMBLY COMPRISING CONDUCTIVE POLYMERS
STRUCTURE ELECTROPHOSPHORESCENTE CONTENANT DES POLYMERES CONDUCTEURS

(30) Priorität: 16.10.2001 DE 10150477
(43) Veröffentlichungstag der Anmeldung: 21.07.2004
(73) Patentinhaber: H.C. Starck GmbH, 38642 Goslar (DE)
(72) Erfinder: HEUER, Helmut-Werner, 47829 Krefeld (DE); WEHRMANN, Rolf, 47800 Krefeld (DE)
(74) Vertreter: Clauswitz, Kai-Uwe Wolfram
(86) Internationale Anmeldenummer: PCT/EP2002/011130
(87) Internationale Veröffentlichungsnummer: WO 2003/034512

(56) Entgegenhaltungen:
- WO-A-00/70566
- WO-A-02/065484
- RU-C- 2 123 773
- US-A- 5 719 467
- US-B1- 6 376 105
- GUSTAFSSON G ET AL: "'Plastic' LED: a flexible light-emitting device using a polyaniline transparent electrode" PROCEEDINGS OF THE INTERNATIONAL CONFERENCE ON SCIENCE AND TECHNOLOGY OF SYNTHETIC METALS, PART 5 (OF 6);GOTEBORG, SWED AUG 12-18 1992, Bd. 57, Nr. 1 part 5, 12. August 1992 (1992-08-12), Seiten 4123-4127, XP002231424 Synth Met;Synthetic Metals; Processing of Polymers, Applications, Langmuir-Blodgett Films, Non-linear Optics, and Polymer Electronics Apr 12 1993 Publ by Elsevier Sequoia SA, Lausanne 1, Switz
- PATENT ABSTRACTS OF JAPAN vol. 200, no. 008, 6. Oktober 2000 (2000-10-06) & JP 2000 133459 A (SEIKO EPSON CORP.), 12. Mai 2000 (2000-05-12)
- PARK J-W ET AL: "Characteristics of organic electroluminescent devices using polypyrrole conducting layer and undoped conjugated polymer layer" THIN SOLID FILMS, ELSEVIER-SEQUOIA S.A. LAUSANNE, CH, Bd. 363, Nr. 1-2, März 2000 (2000-03), Seiten 259-262, XP004189321 ISSN: 0040-6090

## Beschreibung

Die vorliegende Erfindung betrifft eine Schichtanordnung für elektro-optische Vorrichtungen, die ein elektrophosphoreszierendes Material enthält und elektrolumineszierende Anordnungen, die diese Schichtanordnung umfassen.

Elektrolumineszierende Anordnungen sind vielseitig einsetzbar, beispielsweise bei der Herstellung von Bildschirmen oder Displays. Neuerdings steigt das Interesse an emissiven Displays und Anzeigevorrichtungen, besonders unter Ausnutzung der Elektrophosphoreszenz zur Erhöhung der Lichtausbeute (s. Baldo et al., Appl. Phys. Lett., Vol 75, No 1, 4, 1999; WO 00/70 655 A2).

Triplett-basierte Emission von Licht ist unter dem Begriff Phosphoreszenz bekannt (WO 00/70 655 A2). Der Vorteil von Phosphoreszenz gegenüber Fluoreszenz besteht darin, dass der Großteil Triplett-basierter Excitonen, die durch Rekombination von Löchern und Elektronen in einer elektrolumineszierenden Schicht gebildet werden, für einen Energietransfer unter Lumineszenz zur Verfügung stehen.

Um eine möglichst hohe Effizienz einer emittierenden Anordnung zu gewährleisten, ist ein aufeinander abgestimmter Schichtaufbau der elektrolumineszierenden Anordnung notwendig. Aus WO 00/70 655 A2 ist ein solcher Schichtaufbau bekannt, der jedoch sowohl hinsichtlich Langzeitstabilität als auch hinsichtlich der externen Quantenausbeute noch nicht optimal ist. So wird beispielsweise eine Lochinjektionsschicht durch einen Vakuumprozess, d. h. durch Aufdampfen eines niedermolekularen Amins, auf ein Substrat aufgebracht, das mit Indium-Zinn-Oxid (ITO) beschichtet ist. Dabei wird die inhärente Rauhigkeit der ITO-Oberfläche auf dem Substrat zwangsläufig abgebildet und beibehalten. Gerade Rauhigkeiten wirken sich aber im Betrieb einer elektrolumineszierenden Anordnung sehr negativ aus, da sie zu Spannungsspitzen führen, die eine schnellere Alterung und Degradation des Schichtaufbaus zur Folge haben.

In WO 00/70 655 A2 sind organische Licht-emittierende Dioden (OLEDs) beschrieben, die eine Lochleiterschicht und eine Elektronentransportschicht aufweisen. Diese Schichten enthalten Verbindungen, z.B. Tris-(8-hydroxychinolin)aluminium (Alq₃), die sich nur durch einen aufwendigen und teuren Aufdampfprozess applizieren lassen. Wünschenswert wäre die viel einfachere und etablierte Verarbeitung aus Lösung mittels Spin Coating, Casting- oder Ink-Jet-Verfahren.

Zur Herstellung der OLEDs werden gemäß WO 00/70 655 A2 als transparente Substrate Polymerfolien wie Polycarbonat oder andere transparente Polymere verwendet. Diese Substrate werden mit einer leitfähigen Schicht, vorzugsweise Indium-Zinn-Oxid (ITO) versehen. Nachteilig ist jedoch dabei die zu große Rauhigkeit der leitfähigen Schicht, die zu Kurzschlüssen beim Betrieb und zu hohem Ausschuss bei der Fertigung führen kann. Fertigungsbedingt weisen übliche anorganische leitfähige Schichten auf Kunststoffsubstraten stets größere Rauhigkeiten als auf Glas auf. Weiterhin sind anorganische leitfähige Schichten wie ITO spröde, so dass auf flexiblen Unterlagen aufgrund der unterschiedlichen Ausdehnungskoeffizienten bzw. Dehnbarkeit und Zähigkeit Risse auftreten, die zu einer Unterbrechung der elektrischen Leitfähigkeit führen können. Dies tritt besonders bei der Lagerung und/oder Handhabung aufgewickelter Substrate wie z.B. ITO-PET (PET = Polyethylenterephthalat) für roll to roll Prozesse auf.

Aufgabe der Erfindung war daher die Entwicklung neuer Schichtanordnungen, die die. Emission von Licht aus angeregten Triplett-Zuständen ermöglichen und die genannten Nachteile nicht zeigen.

Zur Lösung der Aufgabe wird eine Schicht eines organischen leitfähigen Polymersystems direkt auf die bereits vorhandene leitfähige Schicht, z.B. ITO, des Substrats aufgebracht. Durch Aufbringen des leitfähigen Polymersystems werden Oberflächenrauhigkeiten der leitfähigen Schicht auf dem Substrat, besonders auf Kunststoffsubstraten, ausgeglichen. Weiterhin überspannt das Polymersystem eventuell vorhandene Risse. Es gewährleistet durch seine Dehnbarkeit und Zähigkeit, dass auch nach Handhabung des erfindungsgemäßen Schichtsystems ggf. vorhandene Risse mit leitfähigen Pfaden überspannt bleiben und die Oberflächenleitfähigkeit nicht unterbrochen wird.

Die Erfindung betrifft eine Schichtanordnung, bestehend aus mindestens einem transparenten eine elektrisch leitfähige Schicht enthaltenden Substrat, einer elektro-optisch aktiven Schicht, sowie einem weiteren eine elektrisch leitfähige Schicht enthaltenden Substrat, wobei mindestens eines der beiden elektrisch leitfähigen Substrate zusätzlich mit einem organischen leitfähigen Polymersystem beschichtet ist und die elektro-optisch aktive Schicht eine elektrophosphoreszierende Verbindung enthält.

Die erfindungsgemäße Schichtanordnung erlaubt Lichtemission in Form von Phosphoreszenz und verhindert durch den Einsatz eines elektrisch leitfähigen Polymersystems auf einer transparenten leitfähigen anorganischen Schicht (TCO-Schicht; transparent conductive oxide) auf einem Substrat Kurzschlüsse beim Betrieb von OLEDs, die diese Schichtanordnung enthalten.

Unter elektro-optisch aktiver Schicht wird eine Schicht verstanden, die eine elektro-optische Verbindung enthält, d.h. eine Verbindung, die bei der Rekombination von Elektronen und Löchern Licht emittiert.

Elektrophosphoreszierende Verbindungen im Sinne dieser Anmeldung sind Verbindungen, die bei der strahlenden Rekombination von Elektronen und Löchern Licht unter der Erscheinung der Phosphoreszenz emittieren. Diese Verbindungen zeigen auch die Erscheinung der Photolumineszenz in Form von Phosphoreszenz bei Anregung mit Licht. Im Gegensatz zur Fluoreszenz zeigen die Anregungszustände, die zur Phosphoreszenz führen eine längere Lebensdauer. Die Quanteneffizienz der Fluoreszenz ist durch die Spinstatistik von vorne herein theoretisch begrenzt (25 % Singulettzustände die zur Fluoreszenz führen, im Gegensatz zu 75 % Triplettzuständen). Bei den Phosphoreszenzmaterialien können dagegen alle angeregten Zustände strahlend zerfallen, was sich in einer höheren Quantenausbeute bemerkbar macht.

In einer bevorzugten Ausführungsform der erfindungsgemäßen Schichtanordnung handelt es sich bei der elektrisch leitfähigen Schicht des transparenten Substrats um eine transparente leitfähige anorganische Schicht, wobei auf diese Schicht das organische leitfähige Polymersystem aufgebracht ist.

Bevorzugt wird als transparente anorganische leitfähige Schicht eine Schicht aus Indium-Zinn-Oxid eingesetzt.

Geeignete elektrophosphoreszierende Verbindungen sind aus WO 00/70 655 A2 bekannt. Beispielsweise können phosphoreszierende organische Iridium- oder Osmium-Verbindungen eingesetzt werden.

Bevorzugt wird als elektrophosphoreszierende Verbindung fac-tris(2-Phenylpyridin)iridium der Formel (I) 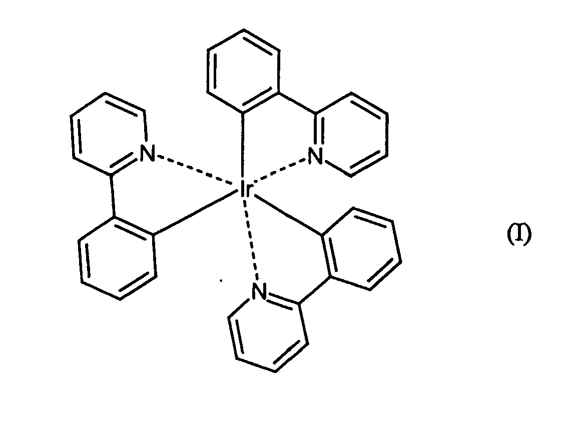 oder substituierte Derivate dieser Grundstruktur eingesetzt.

Insbesondere bevorzugt wird als elektrophosphoreszierende Verbindung unsubstituiertes fac-tris(2-Phenylpyridin)iridium der Formel (I) eingesetzt.

Als Substituenten kommen beispielsweise (C₁-C₈)-Alkyl, Halogen, Cyano (CN) und CF₃ in Frage, wobei sowohl der Phenylring, als auch der Pyridinring der Phenylpyridin-Liganden einen oder mehrere gleiche oder verschiedene Substituenten tragen kann und jeder Phenylpyridin-Ligand vorzugsweise identisch substituiert ist. Vorzugsweise handelt es sich bei den Substituenten um (C₁-C₆)-Alkyl, F oder CF₃, insbesondere bevorzugt um F oder CF₃.

Beispielhaft seien als substituierte Derivate die Verbindungen der Formeln (I-a) und (I-b) angeführt:

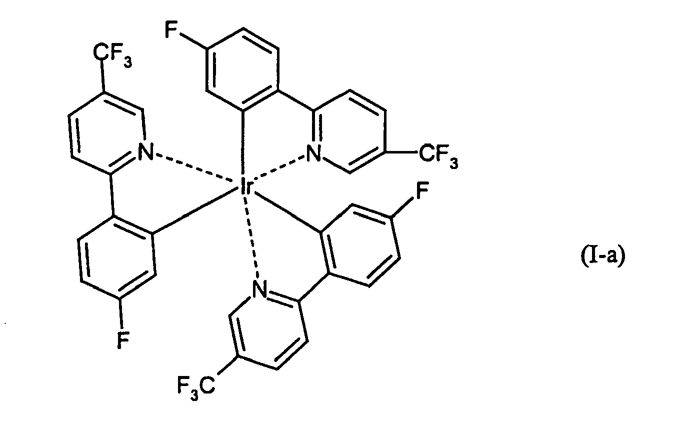

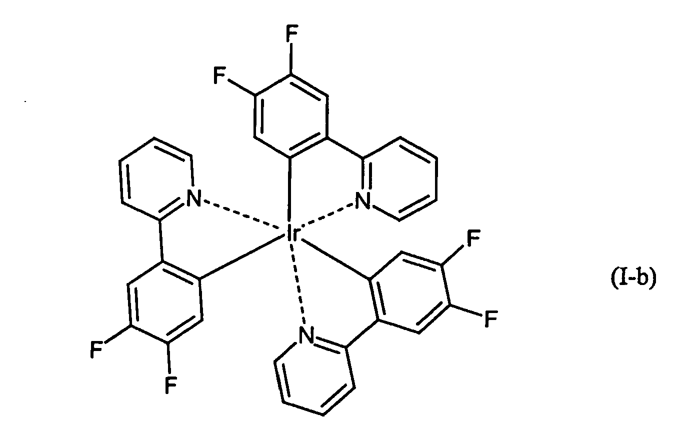

Als elektrophosphoreszierende Verbindung können auch Iridiumkomplexe der allgemeinen Formel (II) 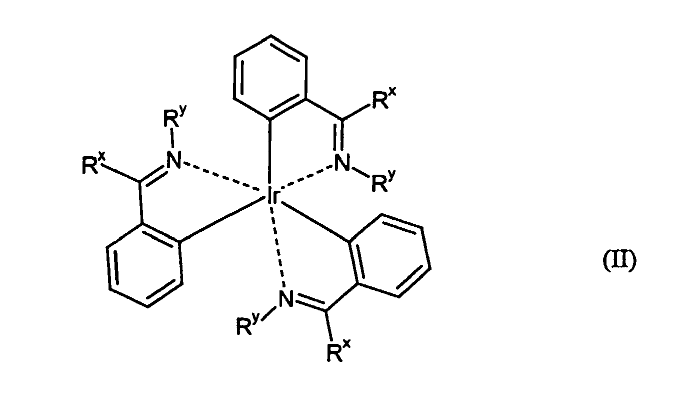 eingesetzt werden, wobei
R^{x} und R^{y} unabhängig voneinander für gegebenenfalls substituiertes (C₁-C₈)-Alkyl, gegebenenfalls substituiertes (C₆-C₁₀)-Aryl oder mit Halogen substituiertes (C₆-C₁₀)-Aryl steht.

Vorzugsweise steht R^{x} und R^{y} unabhängig voneinander für (C₁-C₆)-Alkyl, Phenyl oder Fluor-substituiertes Phenyl, insbesondere für (C₁-C₆)-Alltyl oder Phenyl.

Als Beispiel für einen geeigneten Iridiumkomplex der Formel (II) sei die Verbindung der Formel (II-a) 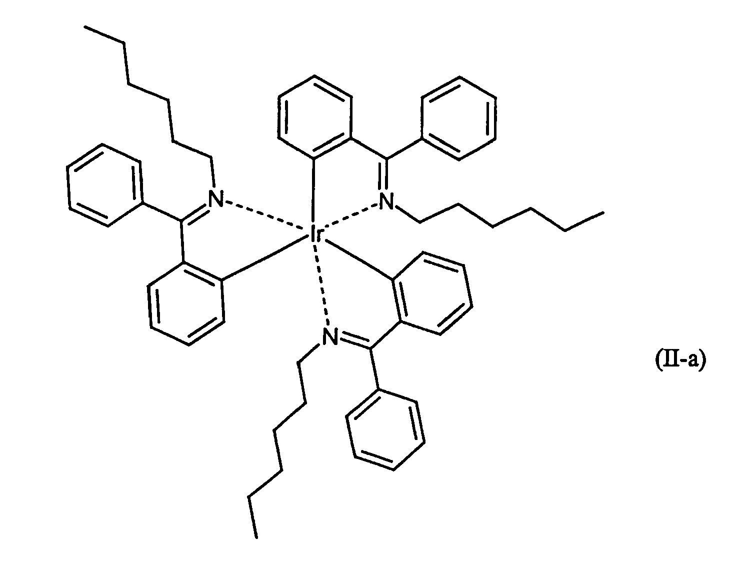 angeführt.

Als elektrophosphoreszierende Verbindung sind weiterhin Iridiumkomplexe der allgemeinen Formel (III) 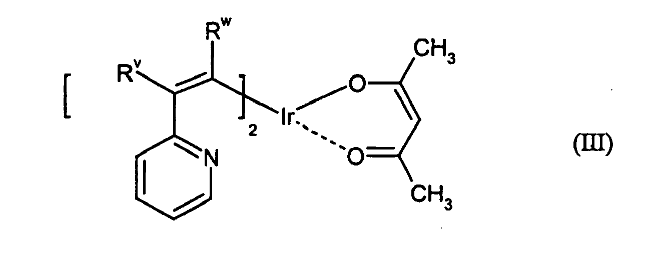 geeignet, wobei
R^{v} und R^{w} gemeinsam einen aromatischen, Schwefel-haltigen Heterocyclus mit 5 oder 6 Ringatomen bilden, wobei an diesen Heterocyclus weitere aromatische Ringe, vorzugsweise C₆-Ringe ankondensiert sein können.

Vorzugsweise bilden R^{v} und R^{w} gemeinsam einen Thiophenring.

Als Beispiel für einen geeigneten Iridiumkomplex der Formel (III) sei die Verbindung der Formel (III-a) 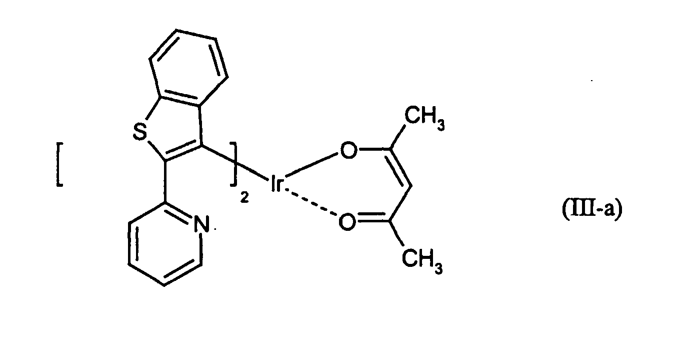 angeführt.

Als elektrophosphoreszierende Verbindung können überdies Iridiumkomplexe der allgemeinen Formel (IV) 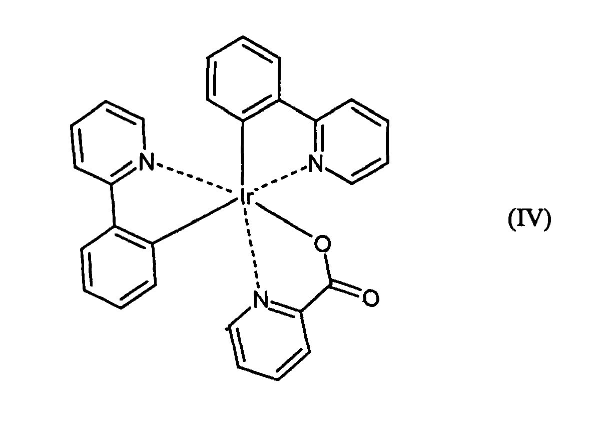 eingesetzt werden, die sich von den Verbindungen der Formel (I) durch Ersatz eines Phenylpyridin-Liganden durch einen Pyridin-2-carbonsäure-Liganden unterscheiden.

Phenylpyridin-Liganden und Pyridin-2-carbonsäure-Ligand können gegebenenfalls substituiert sein. Als Substituenten kommen beispielsweise (C₁-C₈)-Alkyl, Halogen, Cyano (CN) und CF₃ in Frage, wobei sowohl der Phenylring, als auch der Pyridinring der Phenylpyridin-Liganden und der Pyridinring des Pyridin-2-carbonsäure-Liganden einen oder mehrere gleiche oder verschiedene Substituenten tragen können und jeder Phenylpyridin-Ligand vorzugsweise identisch substituiert ist. Vorzugsweise handelt es sich bei den Substituenten um (C₁-C₆)-Alkyl, F oder CF₃, insbesondere bevorzugt um F oder CF₃.

Als Beispiel für einen geeigneten Iridiumkomplex der Formel (IV) sei die Verbindung der Formel (IV-a) 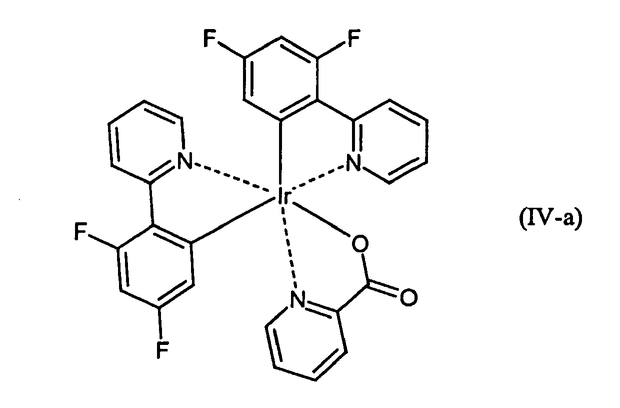 angeführt.

Die aufgeführten Iridiumkomlexe der Formeln (I) bis (IV) lassen sich auf bekannte Weise aus geeigneten Iridiumverbindung, vorzugsweise Iridium(III)acetylacetonat, durch Ligandenaustausch herstellen.

Die Liganden sind teilweise kommerziell verfügbar oder nach gängigen Verfahren herstellbar.

Bei dem organischen leitfähigen Polymersystem kann es sich z.B. um ein System auf Basis von Polyanilinen, Polypyrrolen oder Polythiophenen handeln.

Unter dem leitfähigen Polymersystem wird ein System verstanden, das neben dem eigentlichen organischen leitfähigen Polymer weitere Bestandteile enthalten kann. Dabei kann es sich beispielsweise um Filmbildner, Vernetzer, Thermosolventien, Bindemittel oder die elektrische Leitfähigkeit verbessernde Additive handeln. Beispiele sind in US-A 5 766 515 oder EP-A 602 713 beschrieben.

In einer bevorzugten Ausführungsform der Erfindung ist das organische leitfähige Polymer ein kationisch geladenes Polythiophen aus Struktureinheiten der Formel (V) 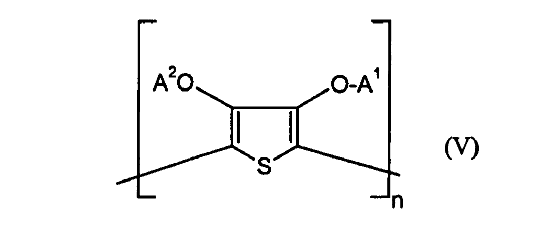 in der
- A¹ und A²: unabhängig voneinander für gegebenenfalls substituiertes (C₁-C₁₈)-Alkyl stehen oder zusammen gegebenenfalls substituiertes (C₁-C₁₈)-Alkylen bilden, und
- n: für eine ganze Zahl von 2 bis 10 000, vorzugsweise 3 bis 5 000 steht,
in Gegenwart von Polyanionen.

Besonders bevorzugte kationische Polythiophene sind aus Struktureinheiten der Formel (Va) oder (Vb) aufgebaut 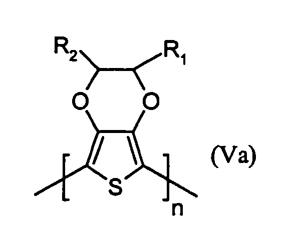 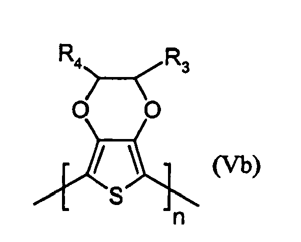 worin
- R₁ und R₂: unabhängig voneinander für Wasserstoff, gegebenenfalls substituiertes (C₁-C₁₈)-Alkyl, vorzugsweise (C₁-C₁₀)-, insbesondere (C₁-C₆)-Alkyl, gegebenenfalls substituiertes (C₂-C₁₂)-Alkenyl, vorzugsweise (C₂-C₈)-Alkenyl, gegebenenfalls substituiertes (C₃-C₇)-Cycloalkyl, vorzugsweise Cyclopentyl, Cyclohexyl, gegebenenfalls substituiertes (C₇-C₁₅)-Aralkyl, vorzugsweise Phenyl-(C₁-C₄)-alkyl, gegebenenfalls substituiertes (C₆-C₁₀)-Aryl, vorzugsweise Phenyl, Naphthyl, gegebenenfalls substituiertes (C₁-C₁₈)-Alkyloxy, vorzugsweise (C₁-C₁₀)-Alkyloxy, beispielsweise Methoxy, Ethoxy, n- oder iso-Propoxy, oder gegebenenfalls substituierten (C₂-C₁₈)-Alkyloxyester steht und
- R₃, R₄: unabhängig voneinander für Wasserstoff, aber nicht beide gleichzeitig, mit mindestens einer Sulfonatgruppe substituiertes (C₁-C₁₈)-Alkyl, vorzugsweise (C₁-C₁₀)-, insbesondere (C₁-C₆)-Alkyl, mit mindestens einer Sulfonatgruppe substituiertes (C₂-C₁₂)-Alkenyl, vorzugsweise (C₂-C₈)-Alkenyl, mit mindestens einer Sulfonatgruppe substituiertes (C₃-C₇)-Cycloalkyl, vorzugsweise Cyclopentyl, Cyclohexyl, mit mindestens einer Sulfonatgruppe substituiertes (C₇-C₁₅)-Aralkyl, vorzugsweise Phenyl-(C₁-C₄)-alkyl, mit mindestens einer Sulfonatgruppe substituiertes (C₆-C₁₀)-Aryl, vorzugsweise Phenyl, Naphthyl, mit mindestens einer Sulfonatgruppe substituiertes (C₁-C₁₈)-Alkyloxy, vorzugsweise (C₁-C₁₀)-Alkyloxy, beispielsweise Methoxy, Ethoxy, n- oder iso-Propoxy oder mit mindestens einer Sulfonatgruppe substituierten (C₂-C₁₈)-Alkyloxyester steht und
- n: für eine Zahl von 2 bis 10 000, vorzugsweise 3 bis 5 000 steht.

Insbesondere bevorzugt steht R₃, R₄ unabhängig voneinander für Wasserstoff, aber nicht beide gleichzeitig, oder einen der oben angegebenen Reste, wobei der Rest mit einer Sulfonatgruppe substituiert ist.

Besonders bevorzugt sind kationische oder neutrale Polyalkylendioxythiophene der Formeln (Va-1) und (Vb-1) 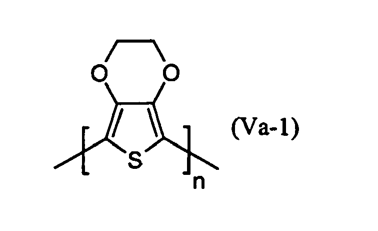 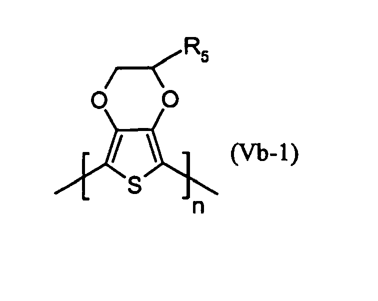 worin
- R₅: für mit mindestens einer Sulfonatgruppe substituiertes (C₁-C₁₈)-Alkyl, vorzugsweise (C₁-C₁₀)-, insbesondere (C₁-C₆)-Alkyl, mit mindestens einer Sulfonatgruppe substituiertes (C₂-C₁₂)-Alkenyl, vorzugsweise (C₂-C₈)-Alkenyl, mit mindestens einer Sulfonatgruppe substituiertes (C₃-C₇)-Cycloalkyl, vorzugsweise Cyclopentyl, Cyclohexyl, mit mindestens einer Sulfonatgruppe substituiertes (C₇-C₁₅)-Aralkyl, vorzugsweise Phenyl-(C₁-C₄)-allcyl, mit mindestens einer Sulfonatgruppe substituiertes (C₆-C₁₀)-Aryl, vorzugsweise Phenyl, Naphthyl, mit mindestens einer Sulfonatgruppe substituiertes (C₁-C₁₈)-Alkyloxy, vorzugsweise (C₁-C₁₀)-Alkyloxy, beispielsweise Methoxy, Ethoxy, n- oder iso-Propoxy oder mit mindestens einer Sulfonatgruppe substituierten (C₂-C₁₈)-Alkyloxyester und
- n: für eine ganze Zahl von 2 bis 10 000, vorzugsweise 3 bis 5 000 steht.

Insbesondere bevorzugt steht R₅ für einen der oben angegebenen Reste, wobei der Rest mit einer Sulfonatgruppe substituiert ist.

In einer weiteren bevorzugten Ausführungsform der Erfindung steht n in den genannten Formeln für eine ganze Zahl von 4 bis 15.

Als Polyanionen dienen die Anionen von polymeren Carbonsäuren, wie Polyacrylsäuren, Polymethacrylsäuren, Polymaleinsäuren und polymeren Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol sein.

Besonders bevorzugt ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Anstelle der für die Bildung der Dispersionen aus Polyalkylendioxythiophenen und Polyanionen erforderlichen freien Polysäuren, kann man auch Gemische aus Alkalisalzen der Polysäuren und entsprechenden Mengen an Monosäuren einsetzen.

Im Falle der Formel (Vb-1) tragen die Polyalkylendioxythiophene positive und negative Ladungen in der Struktureinheit.

Die Herstellung der Polyalkylendioxythiophene ist beispielsweise in EP-A 0 440 957 (= US-A 5 300 575) beschrieben. Die Polyalkylendioxythiophene werden durch oxidative Polymerisation hergestellt. Dadurch erhalten sie positive Ladungen, die in den Formeln nicht dargestellt sind, da ihre Zahl und ihre Position nicht einwandfrei feststellbar sind.

Die Polythiophendispersion kann durch etablierte kostengünstige Verfahren wie Gießen, Drucken, Sprühen, Tauchen, Fluten oder Inkjet auf das transparente leitfähige Substrat aufgebracht werden. Es ist kein kostenintensiver Vakuumprozess notwendig.

In einer bevorzugten Ausführungsform wird auf das elektrisch leitfähige Polymersystem eine Lochleiterschicht, die aromatisches Amin enthält, aufgebracht. Eine Zusammenstellung möglicher Amine ist in EP-A 0 532 798 gegeben.

Vorzugsweise wird ein aromatisches Amin der Formel (VI) 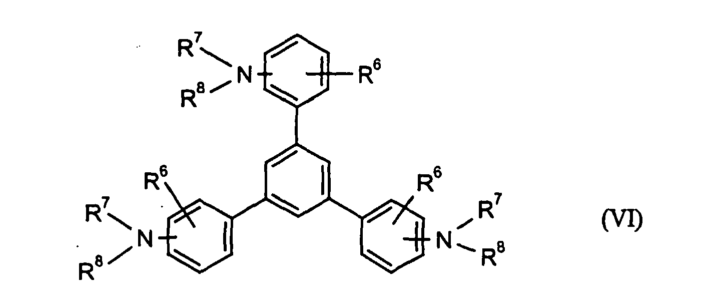 eingesetzt, wobei
- R⁶: für Wasserstoff, gegebenenfalls substituiertes Alkyl oder Halogen steht und
- R⁷ und R⁸: unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen und
- R⁷ und R⁸: stehen unabhängig voneinander bevorzugt für (C₁-C₆)-Alkyl, insbesondere Methyl, Ethyl, n- oder iso-Propyl, n-, iso-, sec.- oder tert.-Butyl, (C₁-C₄)-Alkoxycarbonyl-(C₁-C₆)-alkyl, wie beispielsweise Methoxy-, Ethoxy-, Propoxy-, Butoxycarbonyl-(C₁-C₄)-alkyl, jeweils gegebenenfalls durch (C₁-C₄)-Alkyl und/oder (C₁-C₄)-Alkoxy substituiertes Phenyl-(C₁-C₄)-alkyl, Naphthyl-(C₁-C₄)-alkyl, Cyclopentyl, Cyclohexyl, Phenyl oder Naphthyl.

Besonders bevorzugt stehen R⁷ und R⁸ unabhängig voneinander für unsubstituiertes Phenyl oder Naphthyl oder jeweils einfach bis dreifach durch Methyl, Ethyl, n-, iso-Propyl, Methoxy, Ethoxy, n- und/oder iso-Propoxy substituiertes Phenyl oder Naphthyl.

R⁶ steht vorzugsweise für Wasserstoff, (C₁-C₆)-Alkyl, wie beispielsweise Methyl, Ethyl, n- oder iso-Propyl, n-, iso-, sec.- oder tert.-Butyl, oder Chlor.

Derartige Verbindungen und deren Herstellung sind in US-A 4 923 774 für den Einsatz in der Elektrophotographie beschrieben, welche hiermit ausdrücklich als Bestandteil der Beschreibung aufgenommen wird ("incorporated by reference"). Die Tris-Nitrophenyl-Verbindung kann beispielsweise durch allgemein bekannte katalytische Hydrierung, beispielweise in Gegenwart von Raney-Nickel in die Tris-aminophenyl-Verbindung überführt werden (Houben-Weyl 4/1C, 14-102, Ullmann (4) 13, 135-148). Die Aminoverbindung wird in allgemein bekannter Weise mit substituierten Halogenbenzolen umgesetzt.

Beispielhaft seien folgende Verbindungen genannt:

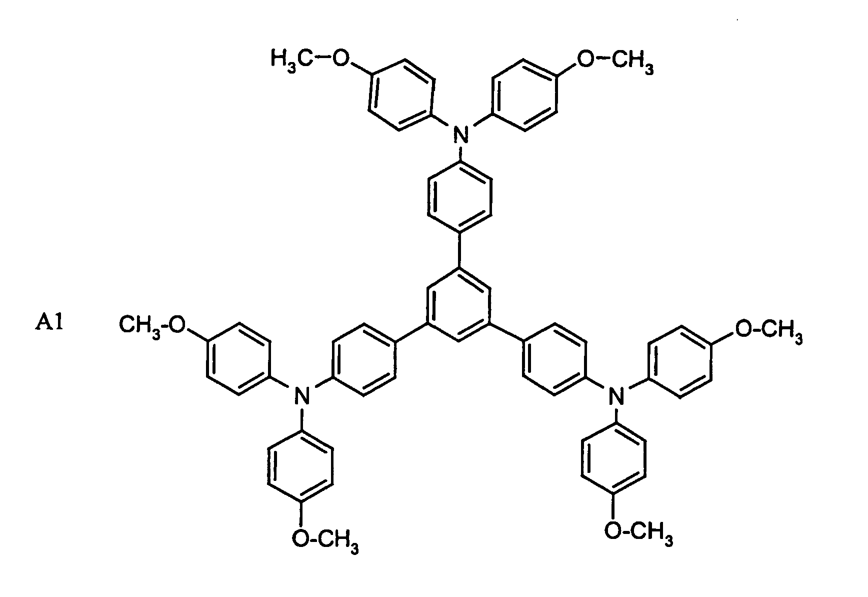

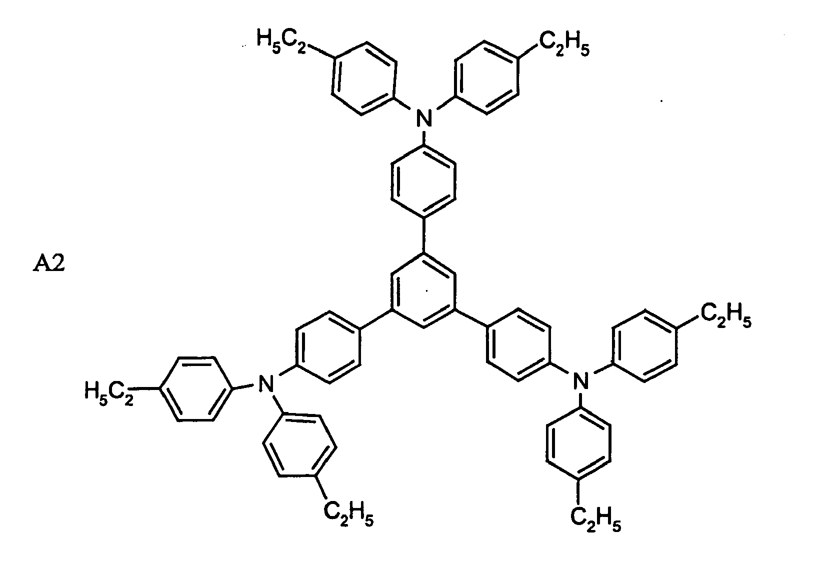

Neben der tertiären Aminoverbindung können gegebenenfalls weitere Lochleiter, z.B. in Form einer Mischung mit der tertiären Aminoverbindung, zum Aufbau des elektrolumineszierenden Elementes eingesetzt werden. Dabei kann es sich einerseits um eine oder mehrere Verbindungen der Formel (VI), wobei auch Gemische von Isomeren umfasst werden, andererseits auch um Mischungen von lochtransportierenden Verbindungen mit tertiären Aminoverbindungen - mit der allgemeinen Formel (VI) - mit verschiedener Struktur handeln.

Eine Zusammenstellung möglicher lochleitender Materialien ist in EP-A 0 532 798 angegeben.

Im Falle von Mischungen der aromatischen Amine können die Verbindungen in einem beliebigen Verhältnis eingesetzt werden.

Beispielhaft seien genannt:

Materialien, die lochleitende Eigenschaften aufweisen und in reiner Form oder als Mischpartner zu den tertiären Aminoverbindungen eingesetzt werden können, sind beispielsweise die folgenden Verbindungen, wobei X¹ bis X⁴ unabhängig voneinander für H, Halogen, Alkyl, Aryl, Alkoxy, Aryloxy stehen.

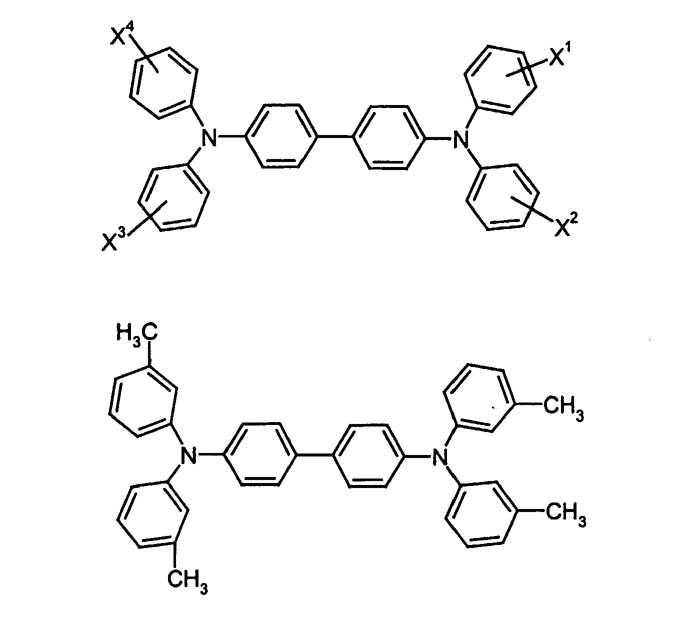

Vorzugsweise umfasst die erfindungsgemäße Schichtanordnung zusätzlich eine Elektronentransportschicht. Eine Vielzahl von Verbindungen, die sich zum Einsatz in einer solchen Schicht eignen, ist bereits bekannt.

So wird gemäß WO 00/70 655 A2 beispielsweise Alq₃ eingesetzt. Bei dieser Verbindung handelt es sich um ein Pigment, das sich auf Grund seiner Unlöslichkeit in gängigen Lösemitteln ausschließlich in einem Aufdamfpprozess aufbringen lässt.

Vorzugsweise wird daher zur Herstellung der Elektronentransportschicht ein Galliumkomplex aus der Gruppe Ga(qa)₂OR⁹, Ga(qa)₂OCOR⁹ oder Ga(qa)₂-O-Ga(qa)₂ eingesetzt, wobei
R⁹ für substituiertes oder unsubstituiertes Alkyl, Aryl, Arylalkyl oder Cycloalkyl und 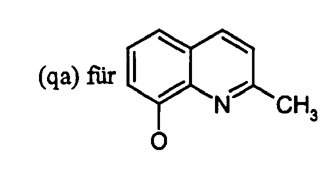 steht.

Diese Gallium-Verbindungen lassen sich im Gegensatz zu Alq₃ sowohl aus Lösung als auch mittels Aufdampfverfahren verarbeiten. Geeignete Lösungsmittel sind beispielsweise Methanol, Ethanol, n-Propanol oder iso-Propanol.

Vorzugsweise steht R⁹ für mit Halogen oder Cyano substituiertes oder unsubstituiertes, gegebenenfalls verzweigtes Alkyl, insbesondere für mit Halogen oder Cyano substituiertes oder unsubstituiertes, gegebenenfalls verzweigtes (C₁-C₈)-Alkyl, besonders bevorzugt für mit Halogen oder Cyano substituiertes oder unsubstituiertes, gegebenenfalls verzweigtes (C₁-C₆)-Alkyl. Als Halogen sind Fluor und Chlor bevorzugt.

Insbesondere bevorzugt werden Gallium-Verbindungen der Formeln (VII) bis (IX) eingesetzt.

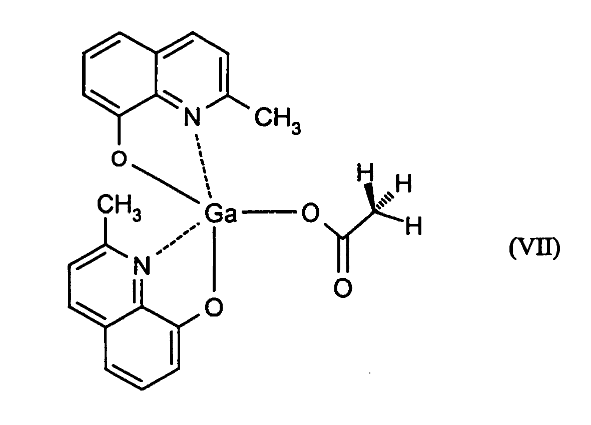

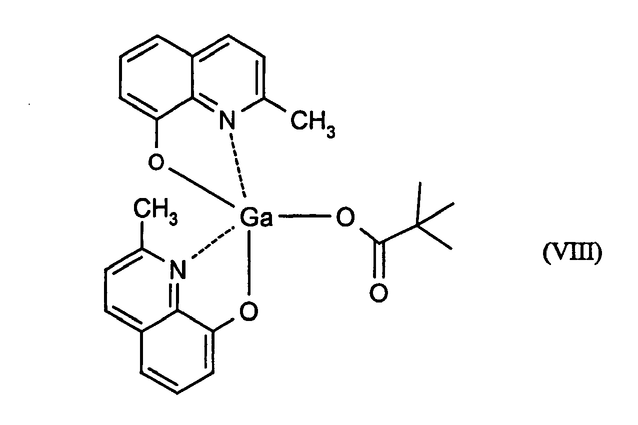

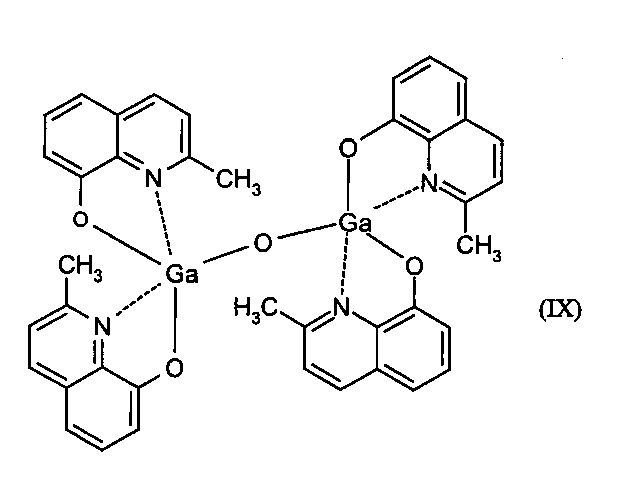

In einer besonderen Ausführungsform enthält die erfindungsgemäße Schichtanordnung zwischen elektro-optisch aktiver Schicht und Elektronentransportschicht eine Barriereschicht.

Vorzugsweise enthält die Barriereschicht Bathocuproin (X).

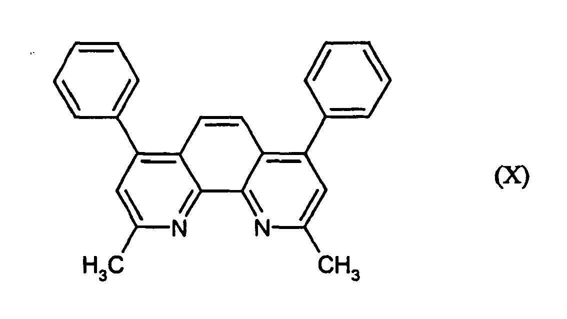

Als transparentes Substrat, das mit einer leitfähigen Schicht versehen ist, sind Glas, Dünnstglas (flexibles Glas) oder Kunststoffe geeignet.

Besonders geeignete Kunststoffe sind: Polycarbonate, Polyester, Copolycarbonate, Polysulfon, Polyethersulfon, Polyimid, Polyethylen, Polypropylen oder cyclische Polyolefine bzw. cyclische Olefincopolymere (COC), hydrierte Styrolpolymere oder hydrierte Styrolcopolymere.

Bevorzugte Polymere sind Polycarbonate, Polyester, Polysulfon, Polyethersulfon, cyclische Olefincopolymere, hydrierte Styrolpolymere und hydrierte Styrolcopolymere. Aus der Gruppe der Polyester sind PET und PEN (Polyethylenterephthalat bzw. Polyethylennaphthenat) bevorzugt.

Geeignete Polymersubstrate sind beispielsweise Polyesterfolien, PES-Folien der Firma Sumitomo oder Polycarbonatfolien der Firma Bayer AG (Makrofol®).

Diese Substrate können durch eine zusätzliche Schicht kratzfest und/oder chemikalienresistent ausgerüstet sein, z.B. Marnot®-Folien (Bayer AG).

Aus der Gruppe der Polycarbonate sind besonders die Poly- oder Copolycarbonate geeignet, die eines der nachfolgenden Segmente enthalten:

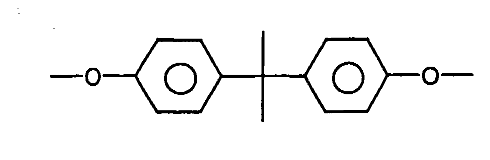

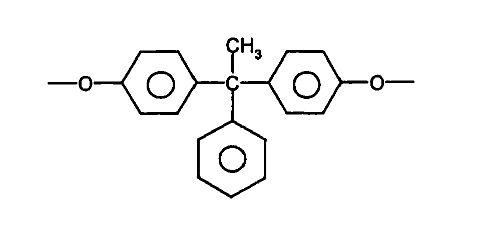

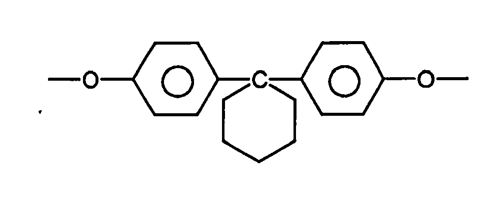

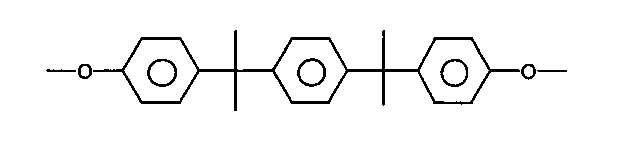

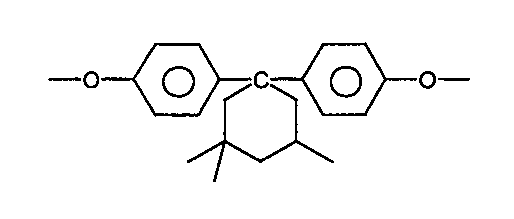

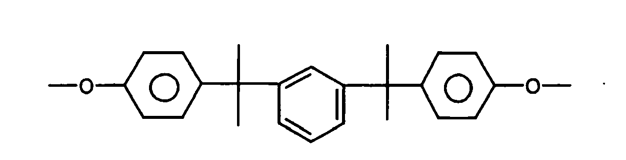

Weitere Bisphenole zum Aufbau von Polycarbonaten sind beispielsweise beschrieben in EP-A 359 953.

Die erfindungsgemäße Schichtanordnung kann gekapselt sein.

Die erfindungsgemäße Schichtanordnung eignet sich insbesondere als elektrolumineszierende Vorrichtung. Demnach sind elektrolumineszierende Vorrichtungen, die eine erfindungsgemäße Schichtanordnung enthalten ebenfalls Gegenstand der Erfindung.

Die erfindungsgemäße Schichtanordnung kann beispielsweise wie folgt hergestellt werden: Ein organisches elektrisch leitfähiges Polymer wird in Form einer Lösung oder Dispersion auf ein mit einer Indium-Zinn-Oxid-Schicht (ITO-Schicht) elektrisch leitfähig beschichtetes Substrat aufgebracht. Ein nachfolgender Temperprozess dient zur Entfernung der Lösungsmittelanteile. Die bevorzugt eingesetzten Amine der Formel (VI) werden anschließend ebenfalls in Form eines Nassbeschichtungsschritts auf die Schicht des organischen leitfähigen Polymersystems aufgebracht. Auch hier erfolgt ein Temperschritt zur Entfernung des Lösungsmittels. Eine nachfolgende elektro-optisch aktive Schicht, sowie gegebenenfalls eine Barriereschicht werden durch einen Aufdampfprozess aufgebracht.

Eine nunmehr folgende Elektronentransportschicht aus einer Galliumkomplexverbindung wird nun vorzugsweise wieder aus einer Lösung, beispielsweise in Methanol, auf die elektro-optisch aktive Schicht bzw. die Barriereschicht aufgebracht. Der Vorteil des erfindungsgemäßen Schichtaufbaus besteht somit auch in der deutlichen Reduzierung der notwendigen Hochvakuumbeschichtungsschritte beim Aufbau aller organischen Funktionsschichten.

Zur Herstellung einer elektrolumineszierenden Anordnung kann dann beispielsweise ein Metallsubstrat aufgebracht werden, das als Kathode dient. Die ITO-Schicht fungiert dabei als Anode.

### Beispiele

### 1. Aufbringen einer leitfähigen Polythiophenschicht (Baytron^{®}P)

Aufbringen der Baytron^{®} P-Schicht auf ITO:
Etwa 10 ml einer Poly(ethylendioxythiophen)/ Polystyrolsulfonsäure-Lösung mit ca. 1,2 Gew.-% Feststoffanteil (BAYER AG, Leverkusen, Baytron^{®} P) wurden filtriert (Millipore HV, 0,45 µm). Ein Substrat wurde anschließend auf eine Lackschleuder gelegt und die filtrierte Lösung auf der ITO-beschichteten Seite des Substrats verteilt. Anschließend wurde die überstehende Lösung durch Rotation des Tellers bei 500 U/min über den Zeitraum von 3 min abgeschleudert. Danach wurde das so beschichtete Substrat 5 min lang bei 110°C auf einer Heizplatte getrocknet. Die Schichtdicke betrug 60 nm (bestimmt mittels Tencor, Alphastep 200).

Tabelle 1 zeigt den Einfluss der Baytron^{®}P-Lösung auf die Oberflächenrauhigkeit des Substrates.

**Tabelle 1**

| | Substrat | Rauhigkeit rₐ (nm) |
|---|---|---|
| a) | Glas/ITO | 2,5 |
| b) | Glas/ITOBaytron^{®}P | 1,6 |
| c) | Polyester (PET)/ITO | 3,9 |
| d) | Polyester (PET)/ITOBaytron^{®}P | 2,5 |

Die Rauhigkeiten wurden mit Hilfe der Rasterkraftmikroskopie (AFM) ermittelt.

Man erkennt deutlich die glättende Wirkung, die die leitfähige Schicht auf die Substratoberfläche ausübt. Das Muster d) weist auch nach mehrmaliger mechanischer Behandlung - Biegen, Rollen etc. - keine sichtbaren Oberflächenrisse auf. Die Baytron^{®}P-beschichteten Substrate können zum Aufbau von elektro-optisch aktiven Anordnungen, wie z.B. Elektrophosphoreszenzanzeigen eingesetzt werden.

## Patentansprüche

1. Schichtanordnung, bestehend aus mindestens einem transparenten eine elektrisch leitfähige Schicht enthaltenden Substrat, einer elektro-optisch aktiven Schicht, sowie einem weiteren eine elektrisch leitfähige Schicht enthaltenden Substrat, **dadurch gekennzeichnet, dass** mindestens eines der beiden elektrisch leitfähigen Substrate zusätzlich mit einem organischen leitfähigen Polymersystem beschichtet ist und die elektro-optisch aktive Schicht eine elektrophosphoreszierende Verbindung enthält.

2. Schichtanordnung gemäß Anspruch 1, **dadurch gekennzeichnet, dass** es sich bei der elektrisch leitfähigen Schicht des transparenten Substrats um eine transparente leitfähige anorganische Schicht handelt und auf dieser Schicht das organische leitfähige Polymersystem aufgebracht ist.

3. Schichtanordnung gemäß Anspruch 2, **dadurch gekennzeichnet, dass** es sich bei der transparenten anorganischen leitfähigen Schicht um Indium-Zinn-Oxid handelt.

4. Schichtanordnung gemäß wenigstens eines der Ansprüche 1 bis 3, **dadurch gekennzeichnet, dass** als elektrophosphoreszierende Verbindung eine phosphoreszierende organische Iridium- oder Osmium-Verbindung eingesetzt wird.

5. Schichtanordnung gemäß Anspruch 4, **dadurch gekennzeichnet, dass** als elektrophosphoreszierende Verbindung eine phosphoreszierende organische Iridium-Verbindung der Formel 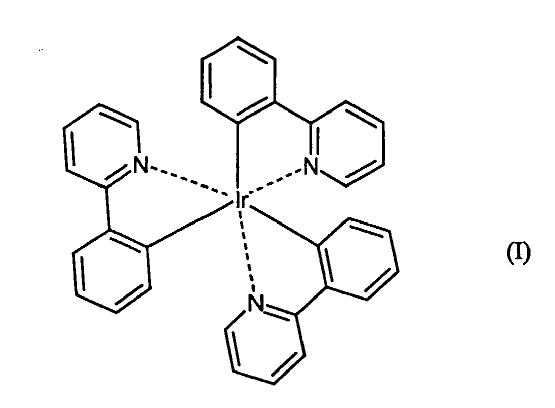 eingesetzt wird.

6. Schichtanordnung gemäß wenigstens eines der Ansprüche 1 bis 5, **dadurch gekennzeichnet, dass** es sich bei dem organischen leitfähigen Polymersystem um ein Polyanilin-, ein Polypyrrol- oder ein Polythiophensystem handelt.

7. Schichtanordnung gemäß Anspruch 6, **dadurch gekennzeichnet, dass** es sich bei dem organischen leitfähigen Polymersystem um ein kationisch geladenes Polythiophen aus Struktureinheiten der Formel (V) 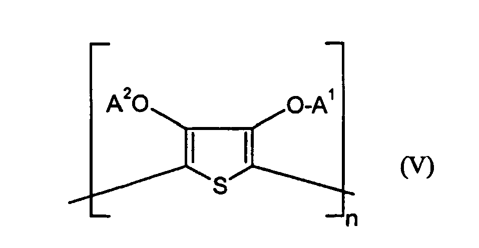 in der
A¹ und A² unabhängig voneinander für gegebenenfalls substituiertes (C₁-C₁₈)-Alkyl stehen oder zusammen gegebenenfalls substituiertes (C₁-C₁₈)-Alkylen bilden, und
n für eine ganze Zahl von 2 bis 10 000, vorzugsweise 3 bis 5 000 steht,
in Gegenwart von Polyanionen, handelt.

8. Schichtanordnung gemäß wenigstens eines der Ansprüche 1 bis 7, **dadurch gekennzeichnet, dass** auf das elektrisch leitfähige Polymersystem zusätzlich eine Lochleiterschicht aufgebracht ist, die ein aromatisches Amin der Formel (VI) 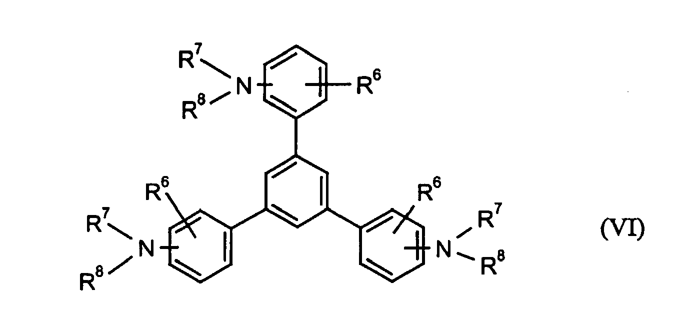 enthält, in welcher
R⁶ für Wasserstoff, gegebenenfalls substituiertes Alkyl oder Halogen steht und
R⁷ und R⁸ unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.

9. Schichtanordnung gemäß wenigstens eines der Ansprüche 1 bis 8, **dadurch gekennzeichnet, dass** sie zusätzlich eine Elektronentransportschicht umfasst, die einen Galliumkomplex aus der Gruppe Ga(qa)₂OR⁹, Ga(qa)₂OCOR⁹, oder Ga(qa)₂-O-Ga(qa)₂ enthält, wobei
R⁹ für substituiertes oder unsubstituiertes Alkyl, Aryl, Arylalkyl oder Cycloalkyl und
(qa)für 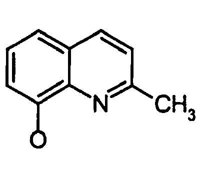 steht.

10. Schichtanordnung gemäß wenigstens eines der Ansprüche 1 bis 9, **dadurch gekennzeichnet, dass** das transparente Substrat aus Glas oder einem Kunststoff besteht.

11. Schichtanordnung gemäß wenigstens eines der Ansprüche 1 bis 10, **dadurch gekennzeichnet, dass** mindestens eines der beiden Substrate ein Kunststoffsubstrat ist.

12. Schichtanordnung gemäß Anspruch 10 oder 11, **dadurch gekennzeichnet, dass** es sich bei dem Kunststoff um Polycarbonat oder Copolycarbonate, Polyester, Polysulfon, Polyethersulfon, Polyimid, Polypropylen, Polyethylen, cyclische Polyolefine, cyclische Olefincopolymere, hydrierte Styrolpolymere oder hydrierte Styrolcopolymere handelt.

13. Schichtanordnung gemäß wenigstens eines der Ansprüche 10 bis 12, **dadurch gekennzeichnet, dass** das Kunststoffsubstrat kratzfest und/oder chemikalienresistent ausgerüstet ist.

14. Schichtanordnung gemäß wenigstens eines der Ansprüche 1 bis 13, **dadurch gekennzeichnet, dass** die Anordnung gekapselt ist.

15. Elektrolumineszierende Vorrichtung, enthaltend eine Schichtanordnung gemäß wenigstens eines der Ansprüche 1 bis 14.

## Claims

1. Layer arrangement consisting of at least one transparent substrate containing an electrically conductive layer, an electro-optically active layer, and also a further substrate containing an electrically conductive layer, **characterized in that** at least one of the two electrically Conductive substrates is additionally coated with an organic conductive polymer system and the electro-optically active layer contains an electrophosphorescent compound.

2. Layer arrangement according to Claim 1, **characterized in that** the electrically conductive layer of the transparent substrate is a transparent conductive inorganic layer and the organic conductive polymer system is applied to this transparent conductive inorganic layer.

3. Layer arrangement according to Claim 2, **characterized in that** the transparent inorganic conductive layer comprises indium tin oxide.

4. Layer arrangement according to at least one of Claims 1 to 3, **characterized in that** the electrophosphorescent compound is a phosphorescent organic iridium or osmium compound.

5. Layer arrangement according to Claim 4, **characterized in that** a phosphorescent organic iridium compound of the formula 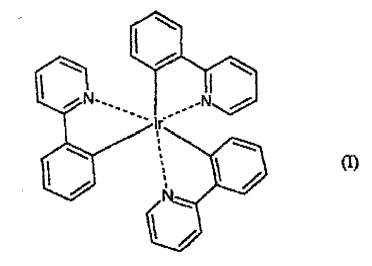 is used as electrophosphorescent compound.

6. Layer arrangement according to at least one of Claims 1 to 5, **characterized in that** the organic conductive polymer system is a polyaniline, polypyrrole or polythiophene system.

7. Layer arrangement according to Claim 6, **characterized in that** the organic conductive polymer system comprises a cationically charged polythiophene comprising structural units of the formula (V) 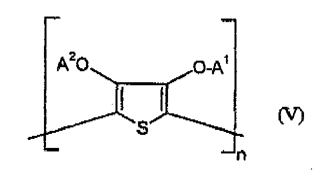 in which
A¹ and A², independently of one another, represent optionally substituted (C₁-C₁₈)-alkyl or together form optionally substituted (C₁-C₁₈)-alkylene, and
n represents an integer from 2 to 10 000, preferably 3 to 5000,
in the presence of polyanions.

8. Layer arrangement according to at least one of Claims 1 to 7, **characterized in that** the electrically conductive polymer system additionally has applied to it a hole conductor layer containing an aromatic amine of the formula (VI) 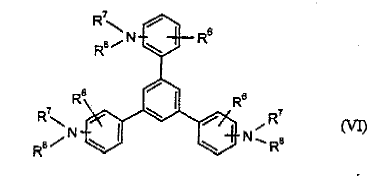 in which
R⁶ represents hydrogen, optionally substituted alkyl or halogen, and
R⁷ and R⁸, independently of one another, represent optionally substituted (C₁-C₁₀)-alkyl, alkoxycarbonyl-substituted (C₁-C₁₀)-alkyl, optionally substituted aryl, optionally substituted aralkyl or optionally substituted cycloalkyl.

9. Layer arrangement according to at least one of Claims 1 to 8, **characterized in that** it additionally comprises an electron transport layer containing a gallium complex selected from the group consisting of Ga(qa)₂OR⁹, Ga(qa)₂OCOR⁹ and Ga(qa)₂-O-Ga(qa)₂, in which
R⁹ represents substituted or unsubstituted alkyl, aryl, arylalkyl or cycloalkyl, and (qa) represents

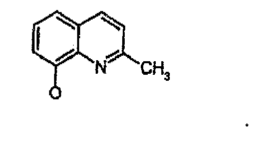

10. Layer arrangement according to at least one of Claims 1 to 9, **characterized in that** the transparent substrate consists of glass or a plastic.

11. Layer arrangement according to at least one of Claims 1 to 10, **characterized in that** at least one of the two substrates is a plastic substrate.

12. Layer arrangement according to Claim 10 or 11, **characterized in that** the plastic is polycarbonate or copolycarbonates, polyester, polysulfone, polyether sulfone, polyimide, polypropylene, polyethylene, cyclic polyolefins, cyclic olefin copolymers, hydrogenated styrene polymers or hydrogenated styrene copolymers.

13. Layer arrangement according to at least one of Claims 10 to 12, **characterized in that** the plastic substrate is scratchproof and/or chemically resistant.

14. Layer arrangement according to at least one of Claims 1 to 13, **characterized in that** the arrangement is encapsulated.

15. Electroluminescent apparatus containing a layer arrangement according to at least one of Claims 1 to 14.

## Revendications

1. Structure stratifiée, constituée d'au moins un substrat transparent contenant une couche conductrice de l'électricité, d'une couche à activité électro-optique, ainsi que d'un autre substrat contenant une couche conductrice de l'électricité, **caractérisée en ce qu'**au moins l'un des deux substrats conducteurs de l'électricité en outre est revêtu d'un système polymère organique conducteur et la couche à activité électro-optique contient un composé éleetrophosphorescent.

2. Structure stratifiée selon la revendication 1, **caractérisée en ce que** la couche conductrice de l'électricité du substrat transparent est une couche inorganique transparente conductrice et le système polymère organique conducteur est appliqué sur cette couche.

3. Structure stratifiée selon la revendication 2, **caractérisée en ce que** la couche conductrice inorganique transparente consiste en oxyde d'indium et d'étain.

4. Structure stratifiée selon au moins l'une des revendications 1 à 3, **caractérisée en ce qu'**on utilise comme composé électrophosphorescent un composé organique d'iridium ou d'osmium phosphorescent.

5. Structure stratifiée selon la revendication 4, **caractérisée en ce qu'**on utilise comme composé électrophosphorescent un composé organique d'iridium phosphorescent de formule

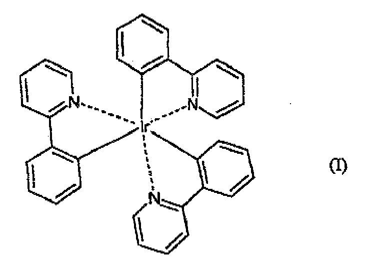

6. Structure stratifiée selon au moins l'une des revendications 1 à 5, **caractérisée en ce que** le système polymère organique conducteur est un système polyaniline, un système polypyrrole ou un système polythiophène.

7. Structure stratifiée selon la revendication 6, **caractérisée en ce que** le système polymère organique conducteur est un polythiophène à charge cationique, constitué de motifs structuraux de formule (V) 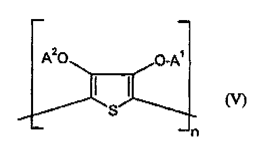 dans laquelle
A¹ et A² représentent, indépendamment l'un de l'autre, un groupe alkyle en C₁-C₁₈ ou forment ensemble un groupe alkylène en C₁-C₁₈ éventuellement substitué, et
n représente un nombre entier allant de 2 à 10 000, de préférence de 3 à 5 000,
en présence de polyanions.

8. Structure stratifiée selon au moins l'une des revendications 1 à 7, **caractérisée en ce qu'**en outre est appliquée sur le système polymère conducteur de l'électricité une couche conductrice à trous qui contient une amine aromatique de formule (VI) 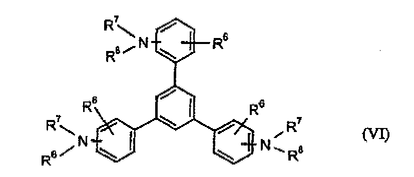 dans laquelle
R⁶ représente un atome d'hydrogène ou d'halogène ou un groupe alkyle éventuellement substitué et
R⁷ et R⁸ représentent, indépendamment l'un de l'autre, un groupe alkyle en C₁-C₁₀ éventuellement substitué, un groupe alkyle en C₁-C₁₀ substitué par alcoxycarbonyle, un groupe alkyle, aralkyle ou cycloalkyle chacun éventuellement substitué.

9. Structure stratifiée selon au moins l'une des revendications 1 à 8, **caractérisée en ce qu'**elle comprend en outre une couche de transport d'électrons, qui contient un complexe de gallium choisi dans l'ensemble constitué par Ga(qa)₂OR⁹, Ga(qa)₂OCOR⁹ et Ga(qa)₂-O-Ga(qa)₂,
R⁹ représentant un groupe alkyle, aryle, arylalkyle ou cycloalkyle, substitué ou non substitué, et
(qa) représentant

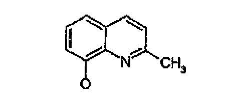

10. Structure stratifiée selon au moins l'une des revendications 1 à 9, **caractérisée en ce que** le substrat transparent est constitué de verre ou d'une matière plastique.

11. Structure stratifiée selon au moins l'une des revendications 1 à 10, **caractérisée en ce qu'**au moins l'un des deux substrats est un substrat en matière plastique.

12. Structure stratifiée selon la revendication 10 ou 11, **caractérisée en ce que** la matière plastique consiste en polycarbonate ou copolycarbonates, polyester, polysulfone, polyéthersulfone, polyimide, polypropylène, polyéthylène, polyoléfines cycliques, copolymères d'oléfines cycliques, polymères de styrène hydrogénés ou copolymères de styrène hydrogénés.

13. Structure stratifiée selon au moins l'une des revendications 10 à 12, **caractérisée en ce que** le substrat en matière plastique est résistant à la rayure et/ou résistants aux substances chimiques.

14. Structure stratifiée selon au moins l'une des revendications 1 à 13, **caractérisée en ce que** la structure est encapsulée.

15. Dispositif électroluminescent, contenant une structure stratifiée selon au moins l'une des revendications 1 à 14.
